Europäisches Patentamt

European Patent Office

Office européen des brevets

(11) Veröffentlichungsnummer: **0 221 428**
**B1**

(12) **EUROPÄISCHE PATENTSCHRIFT**

(45) Veröffentlichungstag der Patentschrift:
23.11.89

(21) Anmeldenummer: 86114511.8

(22) Anmeldetag: 20.10.86

(51) Int. Cl.⁴: **G03F 7/26, G03F 7/16**

(54) **Behandlungsflüssigkeit für ein Photoresistgemisch und hierfür geeignetes Verfahren.**

(30) Priorität: **28.10.85 US 791979**

(43) Veröffentlichungstag der Anmeldung:
**13.05.87 Patentblatt 87/20**

(45) Bekanntmachung des Hinweises auf die Patenterteilung:
**23.11.89 Patentblatt 89/47**

(84) Benannte Vertragsstaaten:
**DE FR GB**

(56) Entgegenhaltungen:
EP-A- 0 043 132
EP-A- 0 164 083
EP-A- 0 164 248
EP-A- 0 164 620
EP-A- 0 195 315
EP-A- 0 219 789
WO-A- 86/03766
DE-A- 3 439 220
GB-A- 2 019 593
US-A- 4 308 340

CHEMICAL ABSTRACTS, Band 48, Nr. 22, 25.
November 1954, Zusammenfassung Nr. 13951f,
Columbus, Ohio, US; V.K. ROWE et al.: "Toxicology of

(73) Patentinhaber: **HOECHST CELANESE CORPORATION,**
**Route 202-206 North, Somerville, N.J. 08876(US)**

(72) Erfinder: **Durham, Dana, RD No. 1 Box 372, Bloomsbury**
**New Jersey 08804(US)**

(74) Vertreter: **Euler, Kurt Emil, Dr. et al, KALLE**
**Niederlassung der Hoechst AG**
**Rheingaustrasse 190 Postfach 3540,**
**D-6200 Wiesbaden 1(DE)**

(56) Entgegenhaltungen: (Fortsetzung)
**mono-, di-, and tri-propylene glycol methyl ethers", &**
**ARCH. IND. HYG. OCCUPATIONAL MED. 9, 509-25, 1954**
**Paint and Resin Bd 53, Nr 5 (1983), Seiten 42-47**

## Beschreibung

Die vorliegende Erfindung betrifft ein organisches Lösemittel für ein strahlungsempfindliches, positiv- oder negativ-arbeitendes Photoresistgemisch. Die Erfindung betrifft auch ein Verfahren zum Behandeln eines mit einem Photoresist versehenen Schichtträgers mit Hilfe von organischen Lösemitteln.

Die Herstellung von Photoresistansätzen ist bekannt und wird zum Beispiel in US-A 3 666 473, US-A 4 115 128 und US-A 4 173 470 beschrieben. Dabei handelt es sich um alkalilösliche Phenolformaldehyd-Novolakharze in Verbindung mit lichtempfindlichen Stoffen, gewöhnlich substituierten Naphthochinondiazidverbindungen. Die Harze und lichtempfindlichen Stoffe werden in einem organischen Lösemittel oder Lösemittelgemisch gelöst und als dünne Schicht bzw. Beschichtung auf einen für den vorgesehenen Verwendungszweck geeigneten Schichtträger aufgebracht.

Die Novolakharzkomponente dieser Photoresistansätze ist in wäßrig-alkalischen Lösungen löslich, wobei aber die lichtempfindliche Naphthochinonverbindung als Inhibitor auf das Harz wirkt. Wenn jedoch bestimmte Bereiche des beschichteten Trägers mit aktinischer Strahlung belichtet werden, erfährt die lichtempfindliche Verbindung eine durch die Bestrahlung induzierte strukturelle Umwandlung, und die belichteten Bereiche der Beschichtung werden löslicher als die unbelichteten.

Das mittels des beschriebenen Verfahrens auf dem Schichtträger erzeugte Photoresistreliefbild kann für zahlreiche Zwecke verwendet werden, wie z.B. als Belichtungsmaske oder Vorlage, wie sie bei der Herstellung von Halbleiterelementen in der Mikroelektronik eingesetzt werden.

Für viele technische Anwendungen, insbesondere für die Herstellung von Halbleiterbauelementen in der Mikroelektronik, muß ein Photoresist einen hohen Bildauflösungsgrad aufweisen, wenn er sehr kleine Linien- und Zwischenraumbreiten (in der Größenordnung von 1 μm) wiedergeben soll.

Die Fähigkeit eines Photoresists zur Wiedergabe sehr kleiner Abmessungen in der Größenordnung von 1 μm und darunter ist bei der Herstellung von VLSI-Schaltungen auf Siliziumchips und ähnlichen Komponenten von größter Bedeutung. Die Schaltungsdichte auf einem solchen Chip kann nur durch eine Steigerung des Bildauflösungsvermögens des Photoresists – vorausgesetzt, es wird mit photolithographischen Verfahren gearbeitet – erhöht werden. Obwohl negativ-arbeitende Photoresists, bei denen die belichteten Bereiche der Resistschicht im Entwickler unlöslich sind und die unbelichteten Bereiche vom Entwickler abgelöst werden, in der Halbleiterindustrie in großem Umfang für diesen Zweck verwendet werden, haben doch die positiv-arbeitenden Photoresists von ihrer Natur her eine höhere Bildauflösung und werden als Ersatz für die negativ-arbeitenden Resists eingesetzt.

Die vorliegende Erfindung betrifft ein organisches Lösemittel zum Entschichten und Reinigen von mit gehärteten oder ungehärteten harzartigen Photoresistgemischen versehenen Schichtträgern und zum Verdünnen von solchen Photoresistgemischen sowie Verfahren zum Entschichten und Reinigen von mit einem positiv- oder negativ-arbeitenden Photoresist versehenen Schichtträger und Verdünnen eines Photoresists.

Es sind zahlreiche Verfahren bekannt, mit deren Hilfe die erwähnten harzartigen Photoresistbeschichtungen auf mechanischem oder chemischem Wege von den jeweiligen Schichtträgern entfernt werden können, doch lassen alle diese Verfahren Wünsche offen. Bei mechanischen Entschichtungsverfahren, z.B. durch Abrakeln, wird in fast allen Fällen die Schichtträgeroberfläche beschädigt. Auch die Verwendung bestimmter chemischer Reagenzien, bzw. Lösemittel führt zu unbefriedigenden Ergebnissen, da die gehärteten Harze zu langsam und/oder unvollständig abgelöst oder die elektrischen Eigenschaften des Materials durch auf dem Schichtträger zurückbleibende Reste beeinträchtigt werden, die auch während der weiteren Verarbeitung nicht vollständig entfernt werden. Daher besteht die Notwendigkeit, ein organisches Lösemittel zur Verfügung zu stellen, mit dessen Hilfe die erwähnten gehärteten Harze sich schnell und vollständig von der Schichtträgeroberfläche entfernen lassen, ohne daß es zu einer Beschädigung oder Verunreinigung des Trägermaterials kommt.

Es sind Lösemittelgemische bekannt, mit deren Hilfe Photoresistgemische verdünnt, unerwünschte gehärtete Photoresistbeschichtungen von den Trägern abgetragen, unerwünschte Randwülste von schleuderbeschichteten Photoresistwafer entfernt und mit denen bei der Verarbeitung von Photoresists verwendete Geräte gereinigt werden können. Doch sind derartige Gemische im allgemeinen sehr giftig und umweltbelastend und/oder besitzen einen unangenehmen Geruch.

Aufgabe der Erfindung ist es, ein organisches Lösemittel zur Verfügung zu stellen, das die beschriebenen Nachteile nicht aufweist.

Die gestellte Aufgabe wird durch ein organisches Lösemittel zum Entschichten und Reinigen von mit gehärteten oder ungehärteten harzartigen positiv- oder negativ-arbeitenden Photoresistgemischen versehenen Schichtträgern und zum Verdünnen dieser Photoresistgemische gelöst, das dadurch gekennzeichnet ist, daß das organische Lösemittel aus einem Gemisch von etwa 1 bis 10 Gewichtsteilen Propylenglykolalkyletheracetat und etwa 1 bis 10 Gewichtsteilen Propylenglykolalkylether besteht.

Sowohl das Acetat als auch der Ether enthalten bevorzugt ($C_1$ bis $C_4$)-Alkylgruppen. Besonders bevorzugt besteht das Gemisch aus Propylenglykolmethyletheracetat und Propylenglykolmethylether.

Aus US-A 4 550 069 ist ein positiv-arbeitendes Photoresistgemisch bekannt, das Propylenglykolalkyletheracetat enthält. Aus DE-A 3 421 160 ist ein positiv-arbeitendes Photoresistgemisch bekannt, das einen Mono-($C_1$ bis $C_4$)-alkylglykolether von 1,2-Propandiol enthält.

Der gleichzeitig mit dieser Patentanmeldung eingereichten EP-A 0 220 645 ist ein positiv-arbeitendes lichtempfindliches Gemisch zu entnehmen, das eine Komponente aus Propylenglykolalkyletheracetat und Propylenglykolalkylether enthält.

Organische Lösemittel, in denen nur eine der beiden Komponenten Propylenglykolalkylether und Propylenglykolalkyletheracetat enthalten sind, weisen einen Nachteil auf: Der Einsatz von Propylenglykolmonomethyletheracetat (PGMEA) bringt etwa für die Hälfte des mit dieser Substanz in Berührung kommenden Personenkreises eine äußerst unangenehme Geruchsbelästigung mit sich, wobei überwiegend Frauen über Beschwerden klagen. Auch die Verwendung von Propylenglykolmonomethylether (PGME) bedeutet für etwa die Hälfte des mit dieser Substanz hantierenden Personenkreises eine starke Geruchsbelästigung, wobei sich in diesem Fall überwiegend Männer beklagen. Dabei ist es jedoch so, daß diejenigen, die den Geruch von PGMEA überaus lästig finden, PGME als angenehm oder wenigstens nicht störend riechend empfinden und umgekehrt. Wenn nun Gemische dieser Lösemittel, also von PGMEA und PGME eingesetzt werden, klagt keine der betroffenen Personengruppen über nennenswerte Beschwerden. Daher können organische Lösemittel, für deren Herstellung Gemische von PGMEA und PGME Verwendung finden, als eine Klasse von Gemischen mit verminderter Geruchsbelästigung bezeichnet werden.

Die Herstellung von Photoresists, insbesondere von positiv-arbeitenden Photoresists, unter Verwendung von lichtempfindlichen Gemischen aus einem Novolak- oder Polyvinylphenolharz, einer lichtempfindlichen Verbindung auf der Basis eines Chinondiazids und eines Lösemittelgemischs ist bekannt.

Die Produktion von Novolakharzen als Bindemittel, die für die Herstellung von lichtempfindlichen Gemischen verwendet werden können, ist auch bekannt. Ein Verfahren zur Herstellung dieser Novolake ist in "Chemistry and Application of Phenolic Resins" (Chemie und Anwendung von Phenolharzen), von A. Knop und W. Scheib, Springer Verlag, New York, 1979, Kapitel 4, beschrieben. Polyvinylphenole sind beispielsweise in US-A 3 869 292 und US-A 4 439 516 beschrieben. Dem Fachmann ist auch die Verwendung von o-Chinondiaziden bekannt, wie in "Light Sensitve Systems" von J. Kosar, John Wiley & Sons, New York, 1965, Kapitel 7.4, beschrieben. Diese lichtempfindlichen Verbindungen gehören zur Gruppe der substituierten lichtempfindlichen Naphthochinondiazide, wie sie üblicherweise in positiv-arbeitenden Photoresistgemischen verwendet werden. Solche Lichtempfindlichkeit verleihenden Verbindungen sind zum Beispiel aus US-A 2 797 213, US-A 3 106 465 , US-A 3 148 983, US-A 3 130 047, US-A 3 201 329, US-A 3 785 825 und US-A 3 802 885 bekannt. Geeignete lichtempfindliche Verbindungen sind zum Beispiel mit phenolischen Verbindungen, wie Hydroxybenzophenonen, kondensiertes 1,2-Naphthochinondiazid-(2)-5-sulfonylchlorid und 1,2-Naphthochinondiazid-(2)-4-sulfonylchlorid.

in bevorzugter Ausführung liegt der Gehalt an festen Bestandteilen des Photoresistgemischs, d.h. an Bindemittel und Chinondiazid, bei etwa 15 bis 99 Gewichtsprozent an Bindemittel und etwa 1 bis 85 Gewichtsprozent an Chinondiazid. Zur Herstellung des Photoresistgemischs werden das Bindemittel und das Diazid so mit einem Lösemittelgemisch, beispielsweise aus Xylol, Butylacetat und Cellosolve-Acetat, gemischt, daß das Lösemittelgemisch in einem Anteil von etwa 40 bis 90 Gewichtsprozent, bezogen auf das Gewicht des gesamten Resistgemischs, vorhanden ist.

Das Verhältnis des im erfindungsgemäßen organischen Lösemittel enthaltenen PGMEA zu PGME kann in Abhängigkeit von den jeweiligen Erfordernissen des Anwenders in weiten Grenzen variiert werden. Das Mischungsverhältnis im organischen Lösemittel liegt zwischen 1:10 und 10:1 Gewichtsteilen. Bevorzugt beträgt das Mischungsverhältnis von PGMEA zu PGME zwischen 7:3 und 3:7, insbesondere zwischen 6:4 und 4:6, und ganz besonders bevorzugt bei etwa 1:1.

Der Lösung aus Bindemittel, lichtempfindlicher Verbindung und Lösemittelgemisch können vor dem Aufbringen auf einen Schichtträger noch Zusätze, wie z.B. Farbmittel, Farbstoffe, Verlaufmittel, Weichmacher, Haftvermittler, Entwicklungsbeschleuniger, weitere Lösemittel und Tenside, z.B. nicht-ionische Tenside, zugegeben werden. Die fertige Photoresistlösung kann nach einem der in der Photoresisttechnik üblichen Verfahren, wie Tauchen, Sprühen und Aufschleudern, auf einen Schichtträger aufgebracht werden. Für das Aufschleudern kann zum Beispiel der Prozentanteil an Feststoffen in der Resistlösung so eingestellt werden, daß sich in Abhängigkeit von der im Einzelfall verwendeten Aufschleudergeschwindigkeit und der für den Aufschleudervorgang angesetzten Zeitspanne eine Beschichtung in der gewünschten Dicke ergibt. Beispiele für geeignete Schichtträger sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Wenn das Photoresistgemisch durch Aufschleudern auf den Wafer aufgetragen wird, besteht die Gefahr, daß sich am Rand des Wafers ein Photoresistwulst bildet. Durch Aufsprühen des Lösemittels des erfindungsgemäßen organischen Lösemittels auf den Rand des sich drehenden Wafers wird ein Verlaufen des Wulstes bewirkt und so eine gleichmäßige Dicke der Photoresistschicht über die gesamte Waferfläche erreicht. Das erfindungsgemäße organische Lösemittel eignet sich auch gut als Verdünner für das Photoresistgemisch. Zu diesem Zweck wird die erfindungsgemäße Lösung dem flüssigen Photoresistgemisch beigefügt, bis dieses den gewünschten Flüssigkeitsgrad erreicht hat.

Nach dem Auftragen des Photoresistgemischs auf den Schichtträger wird das Ganze einer Vortrocknung bei etwa 20 bis 110°C unterworfen. Diese Wärmebehandlung erfolgt, um die Restlösemittelkonzentration im Photoresist durch Verdampfen zu verringern und zu steuern, ohne daß es dabei zu einer merklichen thermischen Zersetzung der lichtempfindlichen Verbindung kommt. Es wird im allgemeinen angestrebt, den Gehalt an Lösemitteln auf ein Minimum zu senken, und diese erste Wärmebehandlung wird daher so lange fortgeführt, bis die Lösemittel im wesentlichen verdampft sind und eine dünne Schicht aus Photoresistgemisch, deren Dicke etwa 1 µm beträgt, auf dem Schichtträger zurückbleibt.

Die mit dem Photoresistgemisch beschichteten und belichteten Schichtträger werden zum Entwickeln gewöhnlich in eine wäßrig-alkalische Entwicklerlösung getaucht. Die Lösung wird vorzugsweise stark bewegt, was zum Beispiel durch Durchblasen von Stickstoff erfolgen kann. Als Entwickler sind beispielsweise wäßrige Alkali-, Ammonium- oder Tetramethylammoniumhydroxidlösungen geeignet.

Gegenstand der vorliegenden Erfindung ist auch ein Verfahren zum Entschichten und Reinigen eines mit Photoresist versehenen Schichtträgers mit Hilfe eines organischen Lösemittels, das dadurch gekennzeichnet ist, daß man als organisches Lösemittel ein Lösemittel verwendet, das aus etwa 1 bis 10 Gewichtsteilen Propylenglykolalkyletheracetat und etwa 1 bis 10 Gewichtsteilen Propylenglykolalkylether besteht.

Das erfindungsgemäße organische Lösemittel ist hervorragend geeignet als Entfernungs-, Entschichtungs-, Reinigungs- und Verdünnungsmittel für Photoresistgemische. Es kann auf belichtete oder unbelichtete, d.h. gehärtete oder ungehärtete Photoresistschichten, die auf geeignete Schichtträger aufgebracht wurden, aufgetragen werden.

Im folgenden Beispiel wird die Erfindung eingehend erläutert. Dieses Beispiel soll jedoch die Erfindung in keiner Weise in ihrem Umfang beschränken, und es soll nicht dahingehend ausgelegt werden, daß es Bedingungen, Parameter oder andere Werte angibt, die zur praktischen Ausführung der Erfindung ausschließlich anzuwenden sind.

Beispiel

Aus den folgenden Bestandteilen wird ein positiv-arbeitendes Photoresistgemisch hergestellt:
23,8% harzartiges Bindemittel (Cresol/Formaldehyd Novolak);
7,0% lichtempfindliche Verbindung (Kondensationsprodukt aus 1,2-Diazonaphthochinon-(2)-5-sulfonylchlorid und 2, 3, 4-Trihydroxybenzophenon; und
69,2% Lösemittelgemisch (Cellosolve-Acetat, n-Butylacetat und Xylol im Verhältnis 8:1:1).

Ein Siliziumwafer wird mit dem erhaltenen Photoresistgemisch beschichtet, bildweise belichtet und entwickelt. Es wird festgestellt, daß in der zur Belichtung verwendeten Vorlage ein Fehler enthalten ist. Daher wird die gesamte Resistschicht durch Eintauchen des Wafers in ein Gemisch aus Propylenglykolmethylether und Propylenglykolmethyletheracetat (Mischungsverhältnis 1:1) von der Waferschicht entfernt. Der Schichtträger kann nach dieser Behandlung für eine erneute Beschichtung verwendet werden.

**Patentansprüche**

1. Organisches Lösemittel zum Entschichten und Reinigen von mit gehärteten oder ungehärteten harzartigen positiv- oder negativ-arbeitenden Photoresistgemischen versehenen Schichtträgern und Verdünnen dieser Photoresistgemische, dadurch gekennzeichnet, daß es aus einem Gemisch von etwa 1 bis 10 Gewichtsteilen Propylenglykolalkyletheracetat und etwa 1 bis 10 Gewichtsteilen Propylenglykolalkylether besteht.

2. Organisches Lösemittel nach Anspruch 1, dadurch gekennzeichnet, daß das Gemisch aus Propylenglykol(C₁–C₄)-alkyletheracetat und Propylenglykolalkyl-(C₁–C₄)-alkylether besteht.

3. Organisches Lösemittel nach Anspruch 1 oder 2, dadurch gekennzeichnet, daß das Gemisch aus Propylenglykolmethyletheracetat und Propylenglykolmethylether besteht.

4. Organisches Lösemittel nach Anspruch 1, dadurch gekennzeichnet, daß das Mischungsverhältnis von Propylenglykolalkyletheracetat und Propylenglykolalkylether bei etwa 1:1 liegt.

5. Verfahren zum Entschichten und Reinigen eines mit einem Photoresist versehenen Schichtträgers mit Hilfe eines organischen Lösemittels, dadurch gekennzeichnet, daß man als organisches Lösemittel ein Lösemittel nach den Ansprüchen 1 bis 4 verwendet.

6. Verfahren zum Verdünnen eines positiv- oder negativ-arbeitenden Photoresistgemisches, dergestalt, daß man ein organisches Lösemittel nach den Ansprüchen 1 bis 4 verwendet.

**Claims**

1. Organic solvent for stripping and cleaning film bases provided with cured or uncured resin-like positive-working or negative-working photoresist mixtures and for diluting said photoresist mixtures, characterized in that it is composed of a mixture of about 1 to 10 parts by weight of propylene glycol alkyl ether acetate and about 1 to 10 parts by weight of propylene glycol alkyl ether.

2. Organic solvent according to Claim 1, characterized in that the mixture is composed of propylene glycol (C₁–C₄)alkyl ether acetate and propylene glycol alkyl (C₁–C₄)alkyl ether (sic).

3. Organic solvent according to Claim 1 or 2, characterized in that the mixture is composed of propylene glycol methyl ether acetate and propylene glycol methyl ether.

4. Organic solvent according to Claim 1, characterized in that the mixing ratio of propylene glycol alkyl ether acetate and propylene glycol alkyl ether is about 1:1.

5. Process for stripping and cleaning a film base provided with a photoresist with the aid of an organic solvent, characterized in that a solvent according to Claims 1 to 4 is used as organic solvent.

6. Process for diluting a positive-working or negative-working photoresist mixture such that an organic solvent according to Claims 1 to 4 is used.

**Revendications**

1. Solvant organique destiné à débarrasser de la couche et à nettoyer des supports de couche munis de mélanges photorésists résineux durcis ou non durcis travaillant en positif ou en négatif et à diluer ces mélanges photorésists, caractérisé en ce qu'il est constitué d'un mélange d'environ 1 à 10 parties en poids d'acétate d'éther alkylique du propylèneglycol et d'environ 1 à 10 parties en poids d'éther alkylique du propylèneglycol.

2. Solvant organique selon la revendication 1, caractérisé en ce que le mélange est constitué d'acétate d'éther alkylique ($C_1$–$C_4$) du propylèneglycol et d'éther alkylique ($C_1$–$C_4$) du propylèneglycol.

3. Solvant organique selon la revendication 1 ou 2, caractérisé en ce que le mélange est constitué d'acétate d'éther méthylique du propylèneglycol et d'éther méthylique du propylèneglycol.

4. Solvant organique selon la revendication 1, caractérisé en ce que le rapport de mélange de l'acétate d'éther alkylique ($C_1$–$C_4$) du propylèneglycol et d'éther alkylique du propylèneglycol est d'environ 1:1.

5. Procédé pour débarrasser de la couche et nettoyer un support de couche muni d'un photorésist à l'aide d'un solvant organique, caractérisé en ce que l'on utilise comme solvant organique un solvant selon les revendications 1 à 4.

6. Procédé de dilution d'un mélange photorésist travaillant en positif ou en négatif de telle sorte que l'on utilise un solvant organique selon les revendications 1 à 4.